# EUROPÄISCHE PATENTSCHRIFT

(11) **EP 1 307 906 B1**
(45) Veröffentlichungstag und Bekanntmachung des Hinweises auf die Patenterteilung: **26.03.2008**
(21) Anmeldenummer: 01958059.6
(22) Anmeldetag: 07.08.2001
(51) Int. Cl.: H01L 21/311, H01L 27/115

(54) **STRUKTURIERUNG FERROELEKTRISCHER SCHICHTEN**
STRUCTURING OF FERROELECTRIC LAYERS
STRUCTURATION DE COUCHES FERROELECTRIQUES

(30) Priorität: 11.08.2000 DE 10039411
(43) Veröffentlichungstag der Anmeldung: 07.05.2003
(73) Patentinhaber: Qimonda AG, 81739 München (DE)
(72) Erfinder: ENGELHARDT, Manfred, 83620 Feldkirchen-Westerham (DE); HINTERMAIER, Frank, 81547 Muenchen (DE); WEINRICH, Volker, F-75013 Paris (FR); HARTNER, Walter, Glen Allen, VA 23060 (US); SCHINDLER, Guenther, 80802 Muenchen (DE)
(74) Vertreter: Ginzel, Christian
(86) Internationale Anmeldenummer: PCT/EP2001/009131
(87) Internationale Veröffentlichungsnummer: WO 2002/015250

(56) Entgegenhaltungen:
- US-A- 6 077 715
- US-A- 6 100 201
- MAEJIMA Y ET AL: "LOW-DAMAGE ECR-PLASMA-ETCHING TECHNIQUE FOR SRBI2TA2O9 (SBT) CAPACITOR IN FERAM DEVICES" 1997 SYMPOSIUM ON VLSI TECHNOLOGY. DIGEST OF TECHNICAL PAPERS. KYOTO, JUNE 10 - 12, 1997, SYMPOSIUM ON VLSI TECHNOLOGY. DIGEST OF TECHNICAL PAPERS, NEW-YORK, US: IEEE, US, 10. Juni 1997 (1997-06-10), Seiten 137-138, XP000894624 ISBN: 0-7803-4143-0
- LEE J K ET AL: "CHARACTERIZATION AND ELIMINATING OF DRY ETCHING DAMAGED LAYER IN PT/PB(ZR0.53TI0.47)O3/PT FERROELECTRIC CAPACITOR" APPLIED PHYSICS LETTERS, AMERICAN INSTITUTE OF PHYSICS. NEW YORK, US, Bd. 75, Nr. 3, 19. Juli 1999 (1999-07-19), Seiten 334-336, XP000850807 ISSN: 0003-6951
- DATABASE COMPENDEX [Online] ENGINEERING INFORMATION, INC., NEW YORK, NY, US; CHO JUN HEE ET AL: "Plasma etching damage to ferroelectric SrBi2Ta2O9 (SBT) thin films and capacitors" Database accession no. E2000525403306 XP002185380 & FERROELECTRIC THIN FILMS VIII;BOSTON, MA, USA NOV 29-DEC 2 1999, Bd. 596, 29. November 1999 (1999-11-29), Seiten 155-159, Mater Res Soc Symp Proc;Materials Research Society Symposium - Proceedings 2000 Materials Research Society, Warrendale, PA, USA

## Beschreibung

Die Erfindung betrifft ein Verfahren zur strukturierung von ferroelektrischen Schichten auf Halbleitersubstraten, die insbesondere für die Herstellung von Speicherkondensatoren auf hochintegrierten FeRAM- und DRAM-Bauelementen verwendet werden.

Zur Herstellung von ferroelektrischen Kondensatoren für Anwendungen in nicht-flüchtigen Halbleiterspeicherbauelementen hoher Integrationsdichte, aber auch für zukünftige hochintegrierte flüchtige DRAM-Halbleiterspeicherbauelemente, werden ferroelektrische Materialien eingesetzt. Diese Materialien sind in der Lage, eine elektrische Polarisierung ohne von außen angelegte Spannung beizubehalten, weswegen sie für nicht-flüchtige Halbleiterspeicher Verwendung finden. Gleichzeitig weisen diese Materialien auch eine sehr hohe relative Dielektrizitätskonstante auf, weswegen sie für hochintegrierte DRAM-Speicherbauelemente zur Erhöhung der Kapazität der Speicherkondensatoren interessant sind.

Bevorzugte ferromagnetische Materialien für Halbleiterspeicher sind Materialien aus der Perowskit-Gruppe. Vertreter der Perowskit-Gruppe sind Kristalle mit der Verbindungsstruktur ABX₃, wobei A vor allem für die Ionen Ca, Ba, Pb, K und seltene Erden steht, B für Ionen wie Ti, Zr, Sn, Nb, Ta u.a. und X für ein Sauerstoff- oder ein Halogenatom. In der Speichertechnologie werden insbesondere SrBi₂Ta₂0₉ (SBT), Pb(Zr, Ti)0₃ (PZT), oder Bi₄Ti₃0₁₂ (BTO) als Dielektrika zwischen den Platten eines Kondensators eingesetzt. Diese Materialien weisen Sauerstoff und kein Halogen als dritten Bestandteil, X₃, auf. Diese Materialien werden auf die Oberfläche aufgetragen und in einem Ferro-Annealprozeßschritt in Sauerstoff bei einer Temperatur um etwa 800°C kristallisiert.

Das Plattenmaterial der Kondensatoren mit ferroelektrischem Dielektrikum ist bevorzugt ein Edelmetall, das den hohen Temperaturen des Ferro-Annealprozeßachrittes im Sauerstoff widersteht oder sich unter diesen Bedingungen ganz oder teilweise in ein leitfähiges Oxid umwandelt. Als Materialien hierfür kommen vor allem Pt, Pd, Ir, Rh, Ru oder Os oder leitende Edelmetalloxide wie IrOₓ, RhOₓ, Ru0ₓ, 0sOₓ, SrRu0₃ in Frage.

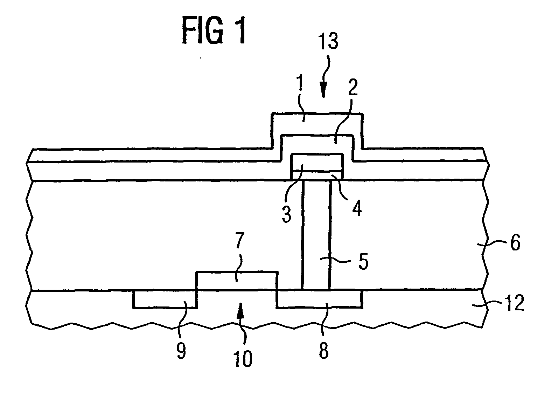

Im allgemeinen wird bei dem Kondensatoraufbau in hochintegrierten Speicherbauelementen das sogenannte Stackprinzip verfolgt, bei dem der Kondensator aus einer Sandwichstruktur aus unterer Elektrode, Dielektrikumsschicht und oberer Elektrode besteht, die auf einer isolierenden Schicht oberhalb der Auswahltransistoren aufgebracht ist. Dieser Aufbau ist in Figur 1 gezeigt. Auf einem Substrat 12 ist ein Auswahltransistor 10 mit Drain 8, Source 9 und Gate 7 aufgebracht. Der Auswahltransistor 10, i.A. ein MOS-FET, stellt den Schalter dar, über den der Speicherkondensator 13, der aus der oberen Elektrodenschicht 1, der ferroelektrischen Schicht 2 und der unteren Elektrode 3 sich zusammensetzt, geladen oder entladen wird. Entsprechend dem Stackprinzip ist der Kondensator 13 auf einer isolierenden Schicht 6 aufgebracht, wobei der Kontakt zwischen dem Speicherkondensator 13 und der Drain 8 des Auswahltransistors 10 durch einen sogenannten Plug 5 hergestellt wird. Ebenfalls in Fig. 1 zu sehen ist die Barrierenschicht 4 zwischen Plug 5 und unterer Elektrode 3, die eine Diffusion des Elektrodenmaterials in das Silizium unterbindet. Die obere Elektrodenschicht 1 wird auch Common-Platte genannt, da ihr Potential für alle Speicherkondensatoren gleich ist.

Die Prozessierung zur Herstellung der Speicherkondensatoren kann z.B. wie folgt ablaufen. Nach Fertigstellung der Transistoren 10 sowie nach Auffüllen mit der isolierenden Schicht 6 wird das Kontaktloch für den Plug 5 geätzt. Es wird mit Plugmaterial aufgefüllt, z.B. mit Poly-Silizium, das anschließend mittels CMP planarisiert wird. Dann wird eine Barrierenschicht und eine Schicht eines der oben erwähnten Edelmetalle abgeschieden. Anschließend werden durch Ätzschritte, z.B. durch MERIE, RIE oder Ion-Milling, die Edelmetallschicht und die Barrierenschicht strukturiert und damit die untere Elektrode 3 fertiggestellt. In alternativer Weise wird mit einer in der isolierenden Schicht versenkten Barriere gearbeitet, auf der eine Edelmetallschicht abgeschieden wird. Anschließend wird die Edelmetallschicht strukturiert.

Als nächster Schritt werden Ferroelektrikum 2 und obere Elektrode 13 abgeschieden. Im Falle von SBT ist nach der Abscheidung ein Hochtemperaturtemperschritt bei 600-800°C in 0₂ für 2 - 90 min nötig, um das abgeschiedene Material in die ferroelektrische Phase zu überführen. Nach der Fertigstellung des Ferroelektrikums und der oberen Elektrode muß erneut strukturiert werden, um Kontaktlöcher für die Bitline 11 zu erzeugen. Diese Strukturierung erfolgt durch einen Ätzprozess. In der Regel wird die Ätzung durch ein Trockenätzverfahren unter Beimischung von halogenhaltigen Gasen wie Cl₂, BCl₃ oder HBr durchgeführt.

Nach dem Strukturierungsschritt wird standardmäßig nachgetempert (Maejima et al.; Symposium on VLSI Technology Digest of Technical Papers (1997), Seite 137-138), und zwar um a) das Interface zwischen oberer Elektrode und Ferroelektrikum auszuheilen und b) um das durch das Ätzen in den Randbereichen geschädigte Ferroelektrikum zu regenerieren. Führt man anschließend eine Leckstromcharakterisierung durch, so stellt sich jedoch heraus, daß die Durchbruchsspannungsfestigkeit des ferroelektrischen Materials gelitten hat; Messungen haben gezeigt, daß die Durchbruchsspannung beim Halogen Ätzverfahren bei einer Schichtdicke von 180 nm schon bei 1-5 V liegt statt bei 8-18 V, wie es andere Ätzverfahren erreichen.

Der Unterschied in der Durchbruchspannung wird darauf zurückgeführt, daß beim Halogenätzprozeß ein Teil der Oxidionen in den ferroelektrischen Materialien durch Halogenidionen ersetzt wird. Dies kann, am Beispiel von SBT als ferroelektrischem Material veranschaulicht, z.B. durch eine Reaktion der folgenden Art geschehen:

SrBi₂Ta₂O₉ + 2x Hal → SrBi₂Ta₂O_{9-X}Hal_{2X} + x/2 O₂

mit Hal= F, Cl, Br, I.

Zusätzlich ist von SBT bekannt, daß es verschiedene Bi-Oxid-Phasen und Bi-haltige Mischoxidphasen gibt, die gute Anionenleiter sind, da sie Anionenleerstellen enthalten. Diese sind vermutlich für die niedrige Durchbruchspannung verantwortlich. Dabei dient die Bi-Oxidhaltige Sekundärphase als Anionenleiter für Halogenid- oder Oxidionen unter den hohen angelegten Feldstärken, welche in der Größenordnung von 5 - 50 x 10⁶ V/m liegen, und sorgt für einen erhöhten, unerwünschten Leckstrom.

Weiterhin hat sich gezeigt, daß das Haftvermögen der oberen Elektrode auf der ferroelektrischen Schicht durch das Halogenätzen leidet. Auch dafür wird der Einbau von Halogenionen in die ferroelektrischen Materialien verantwortlich gemacht, da Ätzverfahren ohne den Einsatz von Halogenen das Haftvermögen nicht beeinträchtigen.

Der vorliegenden Erfindung liegt daher die Aufgabe zugrunde, ein Verfahren zur Strukturierung ferroelektrischer Schichten, insbesondere von ferroelektrischen Schichten, auf denen eine leitende Schicht aufgebracht ist, bereitzustellen, wobei die oben beschriebenen Schwierigkeiten weitgehend vermieden werden sollen.

Diese Aufgabe wird von dem Verfahren zur Strukturierung einer ferroelektrischen Schicht gemäß dem unabhängigen Patentanspruch 1 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Erfindungsgemäß wird ein Verfahren zur Strukturierung einer ferroelektrischen Schicht auf einer Hauptoberfläche eines Halbleitersubstrats mit den folgenden Schritten bereitgestellt:
- das Halbleitersubstrat mit der ferroelektrischen Schicht wird bereitgestellt;
- eine Maske zur Strukturierung der ferroelektrischen Schicht wird bereitgestellt;
- ein Trockenätzschritt mit einem Ätzgasgemisch, das halogenhaltige Gase aufweist, wird durchgeführt;
- nach dem Trockenätzschritt wird ein Temperungsschritt in einer O₂-haltigen Atmosphäre durchgeführt, wobei die Temperatur am Halbleitersubstrat für etwa 2 bis 4 Stunden etwa 500 °C beträgt und danach auf 650 bis 800 °C hochgefahren wird;

Das erfindungsgemäße Verfahren besitzt den Vorteil, daß eine ferroelektrische Schicht ohne die beschriebenen Nachteile strukturiert werden kann. Durch das Trockenätzen mit Ätzgasgemischen, die halogenhaltige Gase aufweisen, wird die Fence-Bildung in den Maskenöffnungen unterdrückt. Durch das Hinzufügen von O₂ wird dabei der für die ferroelektrische Schicht schädliche Einbau von Halogenen in die ferroelektrische Schicht unterdrückt bzw. rückgängig gemacht. Die Rückführung des Sauerstoffs in das ferroelektrische Material, am Beispiel von nicht erfindungsgemäßem H₂O mit SBT als dielektrischem Material gezeigt, kann z.B. durch die Reaktion

SrBi₂Ta₂O_{9-X}Hal_{2X} + x H₂O → SrBi₂Ta₂O₉ + 2HHal_{X}

geschehen, wobei Hal für F, Cl, Br und/oder I steht.

Durch das Hinzufügen von H₂O bzw, erfindungsgemäßem O₂ wird vor allem die elektrostatische Durchbruchsfestigkeit der ferroelektrischen Schicht zurückgewonnen, was insbesondere dann von Bedeutung ist, wenn das Ferroelektrikum als Dielektrikum eines Speicherkondensators dient und elektrische Felder von 5-10 x 10⁶ V/m ohne signifikanten Leckstrom aushalten muß.

Weiterhin wird durch die Zuführung von H₂O oder erfindungsgemäßem O₂ die durch die Trockenätzung mit halogenhaltigen Ätzgasen beeinträchtigte Haftfestigkeit der ferroelektischen Schicht wieder hergestellt. Die Haftfestigkeit spielt z.B. eine besondere Rolle, wenn die ferroelektrische Schicht Dielektrikum zwischen zwei Kondensatorelektrodenschichten ist.

Das Verfahren nach Anspruch 1 betrifft das Nicht-Vorhandensein von H₂O zur Ausheilung der ferroelektrischen Schicht. Die Ausheildung nach Anspruch 1 erfolgt durch eine Reaktion von O₂ mit den Halogenatomen. Im Verfahren nach Anspruch 1 erfolgt

O₂ + 4 Hal⁻ → 2 Hal₂ + 2 O⁻ mit Hal=F, Cl, Br, I.

Der Austausch der Halogenatome im ferroelektrischen Material mit den Sauerstoffatomen erfolgt durch eine 2 bis 4 stündige Temperung des Halbleitersubstrats bei etwa 500 Grad Celsius, wobei nach dieser Zeit die Temperatur auf 650 Grad bis 800 Grad Celsius hochgefahren wird. Das Hochfahren wird bevorzugt so durchgeführt, daß das Halbleitersubstrat etwa 15 bis 30 Minuten lang im Temperaturbereich zwischen 650 und 800 Grad Celsius liegt. Bevorzugt hat die Atmosphäre während der Temperung einen Druck von 1 Atmosphäre. Bevorzugt besteht die Atmosphäre dabei im wesentlichen aus Sauerstoff. Durch diese Temperung werden die durch die Trockenätzung mit dem halogenhaltigen Ätzgasgemisch in das ferroelektrische Material eingebauten Halogenatome durch den Sauerstoff gemäß dem stöchiometrischen Verhältnis ausgetauscht. Das erfindungsgemäße Verfahren besitzt weiterhin den Vorteil, daß es sich gut in den Gesamtprozeßablauf integrieren läßt.

Die Strukturierung der ferroelektrischen Schicht geschieht durch den Trockenätzschritt. Die Trockenätzung erfolgt bevorzugt in einem Plasma. Das Plasma enthält ein Ätzgasgemisch, das halogenhaltige Gase aufweist und für eine ausreichende Ätzrate auf ferroelektrischen Schichten und für eine ausreichende Selektivität sorgt. Die Maske gibt dabei die Struktur der zu strukturierenden Schicht vor. In einer bevorzugten Ausführung besteht die Maske aus einem Siliziumoxid oder einem Nitrid; sie kann aber auch aus einem Lack bestehen, der z.B. nach der Ätzung wieder abgetragen wird. Bevorzugt ist Maske direkt auf der ferroelektrischen Schicht oder auf einer Schicht, die die ferroelektrische Schicht überdeckt, aufgebracht.

Der Temperungsschritt nach dem Trockenätzschritt wird durchgeführt, um die dem Ätzgasgemisch ausgesetzte und damit geschädigte ferroelektrische Schicht auszuheilen und das Haftvermögen der ferroelektrischen Schicht zu den anliegenden Schichten zu verbessern. Die Beschädigung durch das Ätzgasgemisch erfolgt insbesondere an Rändern der geätzten Bereiche, da hier die Maske die ferroelektrische Schicht nicht abdeckt und schützt. Im Falle des Verfahrens gemäß Anspruch 1 findet die Ausheilung der ferroelektrischen Schicht durch eine Temperung in einer O₂-haltigen Atmosphäre statt.

Bevorzugt wird das erfindungsgemäße Verfahren dann verwandt, wenn auf der ferroelektrischen Schicht eine leitende Schicht, insbesondere eine leitende Schicht aus einem Edelmetall oder Edelmetalloxid, aufgebracht ist. Bevorzugt werden dann sowohl die leitende Schicht und die ferroelektrische Schicht in einem Prozeßschritt strukturiert. Bevorzugte leitende Schichten sind insbesondere aus Pt, Pd, Ir, Rh, Ru, oder Os bzw. aus den leitenden Oxiden IrOₓ, RhOₓ, RuOₓ , OsOₓ , SrRuOₓ. Insbesondere wird dieses Verfahren für eine Pt-Schicht auf einer ferroelektrischen Schicht verwandt. Der Trockenätzschritt ist dabei in der Lage, die chemisch schwer zu ätzende Edelmetall- bzw. Edelmetalloxidschicht und die darunterliegende ferroelektrische Schicht in einem Schritt weitgehend anisotrop zu strukturieren. Die halogenartigen Gase verursachen zwar dabei eine Degradation der ferroelektrischen Schicht bzgl. der Durchbruchsspannungsfestigkeit und des Haftvermögens an den geöffneten Randbereichen; diese können jedoch durch die erfindungsgemäße Zugabe von O₂ während der Temperung weitgehend kompensiert werden.

Die ferroelektrische Schicht ist bevorzugt aus Materialien der Perowskit-Gruppe, insbesondere Materialien der sogenannten ABO₃-Klasse, wobei O für Sauerstoff, A und B für Metalle aus der Gruppe Strontium, Kalzium, Barium, Wismut, Kadmium, Blei, Titan, Tantal, Hafnium, Wolfram, Niob, Zirkon, Scandium, Yttrium, Lanthan, Antimon, Chrom oder Tallium stehen. Insbesondere bevorzugt sind SrBi₂Ta₂0₉ (SBT), Pb (Zr, Ti)0₃ (PZT) und/oder Bi₄Ti₃0₁₂ (BTO). Im kristallisierten Zustand sind diese Materialien in der Lage, eine elektrische Polarisation auch ohne äußere Spannung beizubehalten (Remanenz). Damit sind sie als Dielektrika für Speicherkondensatoren nicht-flüchtiger Speicher geeignet. Weiterhin zeichnen sie sich durch eine hohe Dielektrizitätskonstante aus, weswegen sie auch als Dielektrika für Kondensatoren auf höchstintegrierten dynamischen Speicher (DRAMs) eingesetzt werden können.

In einem bevorzugten Verfahren wird die Ätzung durch einen Reactive-Ion-Etch (RIB) Prozeßschritt oder weiterhin bevorzugt, durch einen Magnetic-Enhanced RIE (MERIE) Prozeßschritt, durchgeführt. Diese Verfahren ermöglichen bei der Ätzung einen hohen Grad der Anisotropie und damit eine hohe Maßhaltigkeit der Strukturübertragung. Dies ist Grundvoraussetzung für die Herstellung von sehr hoch integrierten Schaltungen. Der MBRIB Prozeßschritt erlaubt durch die magnetische Plasmaverdichtung zusätzlich eine höhere Ätzrate sowie eine schonende Behandlung der Oberflächen. Die Halogene für die halogenhaltigen Gase sind bevorzugt Cl₂, BCl₃ und/oder HBr.

In einer bevorzugten Ausführung ist die ferroelektrische Schicht Teil von Speicherkondensatoren, wobei die ferroelektrische Schicht das Dielektrikum und die leitende Schicht die obere Elektrode der Speicherkondensatoren ist. Bevorzugt weist das Halbleitersubstrat weiterhin untere Elektroden auf, die zusammen mit der ferroelektrischen Schicht und der oberen Elektrode Speicherkondensatoren bilden. Bevorzugt sind die unteren Elektroden auf einer isolierenden Schicht aufgebracht, die die Auswahltransistoren auf dem Halbleitersubstrat von den unteren Elektroden elektrisch voneinander isoliert. Bevorzugt sind diese Kondensatoren Speicherkondensatoren für DRAM und FeRAM-Halbleiterspeicher, wobei die unteren Elektroden in einer bevorzugten Ausführung mit Auswahltransistoren elektrisch verbunden sind. Die Auswahltransistoren sind dabei bevorzugt auf einem Silizium-, GaAs- oder Ge-Substrat aufgebracht.

Der technische Hintergrund der Erfindung wird nachfolgend anhand von Figuren der Zeichnung näher dargestellt. Es zeigen:
- Fig. 1: Stack-Speicherzelle mit ferroelektrischer Schicht als Dielektrikum nach Stand der Technik.
- Fig. 2a)-2f): Ausführung des Verfahrens zur Strukturierung einer ferroelektrischen Schicht und einer Edelmetallschicht für eine Speicherzelle mit Auswahltransistor und Speicherkondensator.

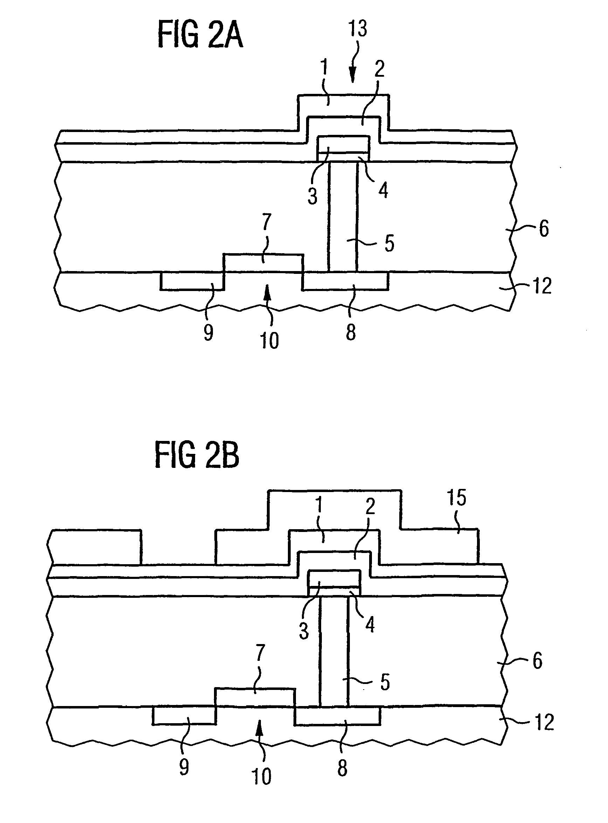

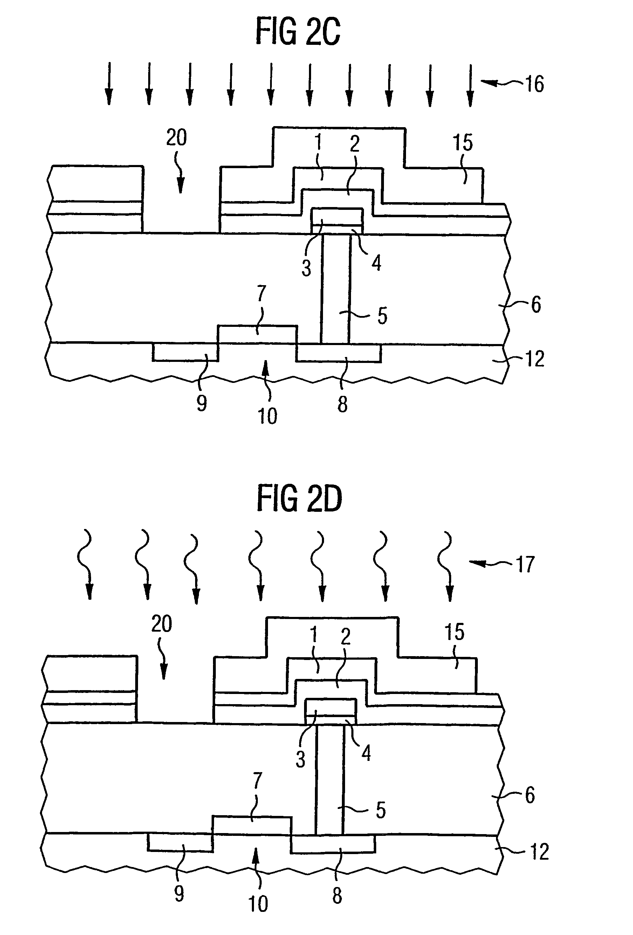

Fig. 2a) bis 2f) zeigen eine Ausführung eines Verfahrens, welches Teil der Prozeßschrittfolge zur Herstellung von nicht-flüchtigen Speicherbauelementen oder hochintegrierten DRAM-Speichern ist. Sie betrifft insbesondere die Erzeugung einer Durchkontaktierung von der Source eines Auswahltransistors durch die ferroelektrische Schicht auf die Oberfläche. Fig.2a) zeigt das Halbleitersubstrat 12 mit der isolierenden Schicht 6 und der unteren Elektrode 3, auf die die ferroelektrische Schicht 2 aufgebracht ist. Das Halbleitersubstrat 12 ist bevorzugt aus Silizium und weist einen Auswahltransistor 10, bestehend aus der Drain 8, der Source 9 und dem Gate 7, auf. Die untere Elektrode ist über den Plug 5 und die Barrierenschicht 4 mit der Drain des Auswahltransistors 10 verbunden. Die leitende Schicht 1 aus Platin, die ferroelektrische Schicht 2 aus bevorzugt SBT und die untere Elektrode, die ebenfalls bevozugt aus Platin ist, bilden zusammen die Speicherkondensatoren 13.

Die ferroelektrische Schicht 2 ist in dieser Ausführung bevorzugt aus SBT, d.h. aus SrBi₂Ta₂0₉. Sie wird bevorzugt bei einem Druck von 9 Torr (1 Torr = 133 Pa) und bei etwa 380 Grad durch einen MOCVD-Schritt mit einer Dicke von 100 nm abgeschieden. Alternativ kann das SBT durch einen Solgel Spin-On Prozeß aufgebracht werden. Nach dem Aufbringen der SBT-Schicht wird die Schicht einem Ferroanneal unterworfen, bei dem die Schicht für 30 Minuten bei etwa 800°C in 1 atm in O₂ getempert wird. Das Tempern kann allerdings auch bei niedrigeren Drücken, niedrigeren Temperaturen und/oder in einer inerten Atmosphäre durchgeführt werden. Durch diesen Verfahrensschritt kristallisiert das SBT und wird ferroelektrisch. Die Platinschicht wird nach dem Ferroanneal mit einer Dicke von etwa 100 nm durch Sputtern auf die SBT-Schicht abgeschieden. Diese Schicht dient als obere Elektrode 1.

Nachdem auf die Hauptoberfläche des Halbleitersubstrats die ferroelektrische Schicht 2 und die obere Elektrode 1 aufgebracht worden sind, müssen Kontaktlöcher von der Oberfläche auf die Source 9 des Auswahltransistors erzeugt werden, über die der Speicherkondensator an eine Bit-Line kontaktiert werden kann. Die Erzeugung der Kontaktlöcher, die die Strukturierung der ferroelektrischen Schicht 2 mit einschließt, ist in den Figuren 2b) bis 2f) gezeigt.

Zunächst wird auf die obere Elektrode 1, die bevorzugt aus Platin ist, eine Maskenschicht aufgebracht und strukturiert, so daß man eine Maske 15 erhält. Die Maske ist bevorzugt aus einem Oxid und/oder Nitrid und ist bevorzugt auf photolithographischem Wege erzeugt worden (Fig. 2b)).

Nach dem Aufbringen der Maske wird der Trockenätzschritt mit einem Ätzgasgemisch, das bevorzugt halogenhaltige Gase aufweist, durchgeführt. Fig. 2c) zeigt den Trockenätzschritt, in dem das beschleunigte ionisierte Ätzgasgemisch 16 weitgehend senkrecht auf die zu strukturierende Hauptoberfläche des Halbleitersubstrats auftrifft und an den Maskenöffnungen der Maske 15 ein weitgehend isotropes Ätzloch durch die Platinschicht 1 und durch die SBT-Schicht 2 erzeugt. In dieser Ausführung des Verfahrens enthält das Ätzgasgemisch bevorzugt chlorhaltige Gase, insbesondere Cl₂, HCl, BCl₃ und/oder SiCl₄. Zusätzlich können Inert-Gase wie Ar, N₂ und/oder O₂ dem Ätzgas zugesetzt sein. In dieser bevorzugten Ausführung wird der Trockenätzschritt im Magnetic-Enhanced-RIE (MERIE) Prozeß bei einer magnetischen Feldstärke von 40-100 Gauss, einem Fluß von 25 bis 150 sccm und bei einer Temperatur am Halbleitersubstrat zwischen 20 und 500°C durchgeführt.

Nach dem Trockenätzschritt wird das Halbleitersubstrat 12 einem Temperungsschritt unterzogen. Dabei wird die Temperung in einer Atmosphäre unter Zusatz von Sauerstoff und Wasserdampf 17 bei einer Temperatur am Halbleitersubstrat von bevorzugt 400°C bis 900°C und bei einem Druck zwischen 0.01 atm und 10 atm durchgeführt. Die Atmosphäre besteht zwischen 0% und 99,9% aus Sauerstoff und weist einen Wasserdampfpartialdruck von 0.001 - 1 des Gesamtdrucks auf. Die Temperzeit liegt zwischen 1 Minute und 120 Minuten. Wird der Wasserdampf durch Verbrennung wasserstoffhaltiger Gase mit dem Sauerstoff erzeugt, so ist unter dem Wasserdampfpartialdruck derjenige Druck zu verstehen, der sich bei vollständiger Verbrennung der wasserstoffhaltigen Gase ergibt. Der Zusatz von Wasserdampf 17 wechselwirkt mit dem offenen Randgebiet der ferroelektrischen Schicht 2 in dem Ätzloch 20, indem das Sauerstoffatom des Wassermoleküls bevorzugt zwei durch den Trockenätzschritt angelagerte Halogenatome im SBT ersetzt. Durch diesen Prozeß wird das ursprüngliche SBT wieder erzeugt, womit sich wieder eine hohe Durchbruchsspannungsfestigkeit und gutes Haftvermögen der ferroelektrischen Schicht 2 auch in den Randbereichen im Ätzloch einstellt.

In einer Ausführung wird das Halbleitersubstrat 12 mit der ferroelektrischen Schicht 2 bei etwa 800°C und bei einem Druck von 1 atm und einem O₂ Gasfluß von 1000 sccm über 15 Minuten getempert. Gleichzeitig wird ein Ar - H₂ Gemisch mit einem Ar-Fluß von 500 sccm und einem H₂-Fluß von 25 ccm dazugeleitet, um mit dem O₂ Gas zu Wasser zu verbrennen. Alternativ kann statt des Ar- H₂ Gasgemisches auch Formiergas (95% N2 und 5% H₂) zum Temperungsofen zugeführt werden.

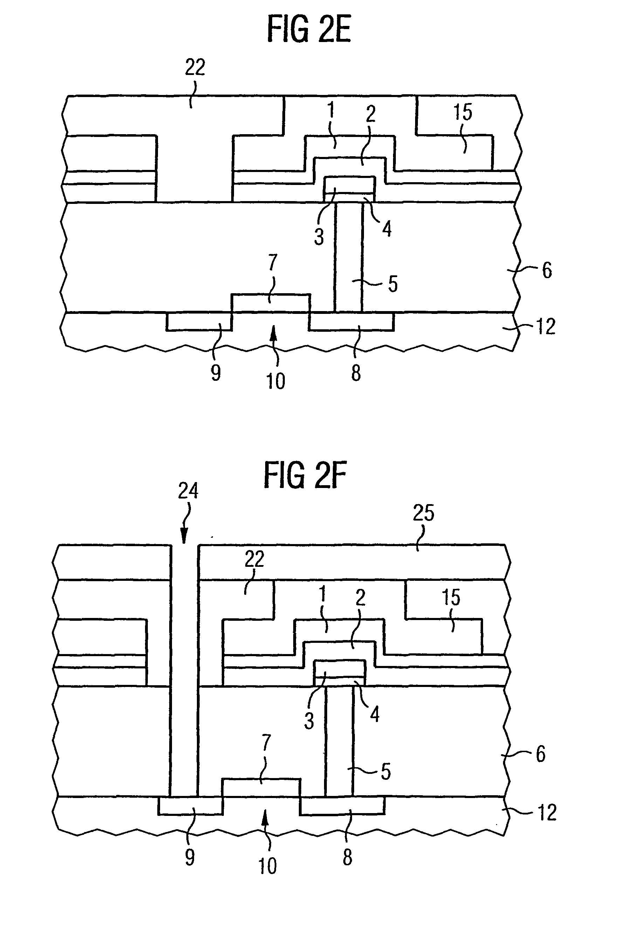

Nachdem die ferroelektrische Schicht strukturiert und wieder ausgeheilt ist, wird die Oberfläche mit einer zweiten isolierenden Schicht 22, bevorzugt mit einem Oxid oder Nitrid, überdeckt und planarisiert (Fig. 2e)). Die zweite isolierende Schicht 22 hat unter anderem die Aufgabe die Schichtkante der oberen Elektrode 1 elektrisch isolierend abzudecken, damit anschließend ein Kontaktloch zur Source 9 erzeugt und mit leitendem Material gefüllt werden kann.

Fig. 2f) zeigt das Halbleitersubstrat, nachdem eine zweite Maske 25 aufgebracht und strukturiert worden ist, um damit das Kontaktloch 24 durch die zweite isolierende Schicht 22 und die isolierende Schicht 6 auf die Source zu ätzen. Das Erzeugen und Strukturieren der zweiten Maske 25 sowie das Erzeugen des Kontaktlochs 24 geschieht mit Verfahren nach Stand der Technik. Anschließend wird das Kontaktloch 24 mit einem leitenden Material gefüllt, so daß die Source 9 von oben kontaktiert werden kann.

## Patentansprüche

1. Verfahren zur Strukturierung einer ferroelektrischen Schicht auf einer Hauptoberfläche eines Halbleitersubstrats mit den folgenden Schritten:
- das Halbleitersubstrat mit der ferroelektrischen Schicht wird bereitgestellt;
- eine Maske zur Strukturierung der ferroelektrischen Schicht wird bereitgestellt;
- ein Trockenätzschritt mit einem Ätzgasgemisch, das halogenhaltige Gase aufweist, wird durchgeführt;
- nach dem Trockenätzschritt wird ein Temperungsschritt in einer O₂-haltigen Atmosphäre durchgeführt, **dadurch gekennzeichnet, daß** beim Temperungsschritt die Temperatur am Halbleitersubstrat für etwa 2 bis 4 Stunden etwa 500 Grad Celsius beträgt und danach auf 650 bis 800 Grad Celsius hochgefahren wird.

2. Verfahren nach Anspruch 1,
**dadurch gekennzeichnet, daß**
die O₂-haltige Atmosphäre beim Temperungsschritt einen Druck von etwa 1 Atmosphäre hat.

3. Verfahren nach Anspruch 1 oder 2,
**dadurch gekennzeichnet, daß**
daß die O₂-haltige Atmosphäre beim Temperungsschritt im wesentlichen aus O₂ besteht.

4. Verfahren nach einem der Ansprüche 1 bis 3,
**dadurch gekennzeichnet, daß**
die Temperatur am Halbleitersubstrat beim Temperungsschritt für etwa 15 bis 30 Minuten im Bereich zwischen 650 und 800 Grad Celsius liegt.

5. Verfahren nach einem der vorhergehenden Ansprüche,
**dadurch gekennzeichnet, daß**
auf der ferroelektrischen Schicht eine leitende Schicht aufgebracht ist.

6. Verfahren nach Anspruch 5,
**dadurch gekennzeichnet, daß**
die leitende Schicht ein Edelmetall, insbesondere Pt, Pd, Ir, Rh, Ru oder Os, oder ein Edelmetalloxid ist.

7. Verfahren nach einem der vorhergehenden Ansprüche,
**dadurch gekennzeichnet, daß**
die ferroelektrische Schicht aus Materialien aus der Perowskit-Gruppe, insbesondere SBT, PZT und/oder BTO, ist.

8. Verfahren nach einem der vorhergehenden Ansprüche,
**dadurch gekennzeichnet, daß**
der Trockenätzschritt ein Reactive-Ion-Etch (RIE) Prozeßschritt, insbesondere ein Magnetic-Enhanced RIB (MERIE) Prozeßschritt ist.

9. Verfahren nach einem der vorhergehenden Ansprüche,
**dadurch gekennzeichnet, daß**
das Ätzgasgemisch Cl₂, BCl₃ und/oder HBr enthält.

10. Verfahren nach einem der Ansprüche 1 und 5 bis 9,
**dadurch gekennzeichnet, daß**
die ferroelektrische Schicht Teil von Speicherkondensatoren ist, wobei die ferroelektrische Schicht das Dielektrikum und die leitende Schicht die obere Elektrode der Speicherkondensatoren sind.

11. Verfahren nach Anspruch 10,
**dadurch gekennzeichnet, daß**
das Halbleitersubstrat untere Elektroden an der Hauptoberfläche aufweist, die zusammen mit der ferroelektrischen Schicht und der oberen Elektrode Speicherkondensatoren bilden.

12. Verfahren nach Anspruch 11,
**dadurch gekennzeichnet, daß**
die unteren Elektroden elektrisch mit Auswahltransistoren verbunden sind, die auf dem Halbleitersubstrat aufgebracht sind.

13. Verfahren nach einem der vorhergehenden Ansprüche,
**dadurch gekennzeichnet, daß**
das Halbleitersubstrat im wesentlichen aus Silizium, GaAs und/oder Ge ist.

14. Verfahren nach einem der Ansprüche 10 bis 13,
**dadurch gekennzeichnet, daß**
die Speicherkondensatoren Teil eines FeRAM- oder DRAM-Speicherbauelements sind.

## Claims

1. Method for patterning a ferroelectric layer on a main surface of a semiconductor substrate, having the following steps:
- the semiconductor substrate with the ferroelectric layer is provided;
- a mask for patterning the ferroelectric layer is provided;
- a dry etching step using an etching gas mixture having halogen-containing gases is carried out;
- after the dry etching step, a heat treatment step is carried out in an O₂-containing atmosphere, **characterized in that**, during the heat treatment step, the temperature at the semiconductor substrate is about 500° celsius for about 2 to 4 hours and then is driven up to 650 to 800° celsius.

2. Method according to Claim 1,
**characterized in that**
the O₂-containing atmosphere during the heat treatment step has a pressure of about 1 atmosphere.

3. Method according to Claim 1 or 2,
**characterized in that**
the O₂-containing atmosphere during the heat treatment step essentially comprises O₂.

4. Method according to one of Claims 1 to 3,
**characterized in that**
the temperature at the semiconductor substrate during the heat treatment step lies in the range between 650 and 800° celsius for about 15 to 30 minutes.

5. Method according to one of the preceding claims,
**characterized in that**
a conductive layer is applied on the ferroelectric layer.

6. Method according to Claim 5,
**characterized in that**
the conductive layer is a noble metal, in particular Pt, Pd, Ir, Rh, Ru or Os, or a noble metal oxide.

7. Method according to one of the preceding claims,
**characterized in that**
the ferroelectric layer is made of materials from the perovskite group, in particular SBT, PZT and/or BTO.

8. Method according to one of the preceding claims,
**characterized in that**
the dry etching step is a reactive ion etch (RIE) process step, in particular magnetic enhanced RIE (MERIE) process step.

9. Method according to one of the preceding claims,
**characterized in that**
the etching gas mixture contains Cl₂, BCl₃ and/or HBr.

10. Method according to one of Claims 1 and 5 to 9,
**characterized in that**
the ferroelectric layer is part of storage capacitors, the ferroelectric layer being the dielectric and the conductive layer being the top electrode of the storage capacitors.

11. Method according to Claim 10,
**characterized in that**
the semiconductor substrate has bottom electrodes at the main surface which form storage capacitors together with the ferroelectric layer and the top electrode.

12. Method according to Claim 11,
**characterized in that**
the bottom electrodes are electrically connected to selection transistors which are applied on the semiconductor substrate.

13. Method according to one of the preceding claims,
**characterized in that**
the semiconductor substrate is essentially made of silicon, GaAs and/or Ge.

14. Method according to one of Claims 10 to 13,
**characterized in that**
the storage capacitors are part of an FeRAM or DRAM memory component.

## Revendications

1. Procédé de structuration d'une couche ferroélectrique sur la surface principale d'un substrat semi-conducteur comprenant les stades suivants :
- on se procure le substrat semi-conducteur ayant la couche ferroélectrique ;
- on se procure un masque de structuration de la couche ferroélectrique ;
- on effectue un stade d'attaque à sec par un mélange de gaz d'attaque qui a des gaz halogénés ;
- après le stade d'attaque à sec, on effectue un stade de mise en température dans une atmosphère contenant du O₂,
**caractérisé en ce que**, dans le stade de mise en température, la température du substrat semi-conducteur est pendant environ 2 à 4 heures d'environ 500 degrés Celsius et est portée ensuite jusqu'à 650 à 800 degrés Celsius.

2. Procédé suivant la revendication 1,
**caractérisé en ce que** l'atmosphère contenant du O₂ a, dans le stade de mise en température, une pression d'environ 1 atmosphère.

3. Procédé suivant la revendication 1 ou 2,
**caractérisé en ce que** l'atmosphère contenant du O₂ est constituée au stade de mise en température essentiellement de O₂.

4. Procédé suivant l'une des revendications 1 à 3,
**caractérisé en ce que** la température du substrat semi-conducteur dans le stade de mise en température est pour environ 15 à 30 minutes comprise entre 650 et 800 degrés Celsius.

5. Procédé suivant l'une des revendications précédentes,
**caractérisé en ce que** l'on dépose une couche conductrice sur la couche ferroélectrique.

6. Procédé suivant la revendication 5,
**caractérisé en ce que** la couche conductrice est un métal précieux, notamment Pt, Pd, Ir, Rh, Ru ou Os ou un oxyde de métal précieux.

7. Procédé suivant l'une des revendications précédentes,
**caractérisé en ce que** la couche ferroélectrique est en matériaux choisis dans le groupe des perowskites, notamment SBT, PZT et/ou BTO.

8. Procédé suivant l'une des revendications précédentes,
**caractérisé en ce que** le stade d'attaque à sec est un stade opératoire Reactive-Ion-Etch (RIE), notamment un stade opératoire Magnetic-Enhanced RIE (MERIE).

9. Procédé suivant l'une des revendications précédentes,
**caractérisé en ce que** le mélange de gaz d'attaque contient du Cl₂, du BCl₃ et/ou de l'HBr.

10. Procédé suivant l'une des revendications 5 à 9,
**caractérisé en ce que** la couche ferroélectrique fait partie de condensateurs de mémoire, la couche ferroélectrique étant le diélectrique et la couche conductrice étant l'électrode supérieure des condensateurs de mémoire.

11. Procédé suivant la revendication 10,
**caractérisé en ce que** le substrat semi-conducteur a, sur la surface principale, des électrodes inférieures qui forment ensemble avec la couche ferroélectrique et les électrodes supérieures des condensateurs de mémoire.

12. Procédé suivant la revendication 11,
**caractérisé en ce que** les électrodes inférieures sont reliées électriquement à des transistors de sélection qui sont déposés sur le substrat semi-conducteur.

13. Procédé suivant l'une des revendications précédentes,
**caractérisé en ce que** le substrat semi-conducteur est essentiellement du silicium, du GaAs et/ou du Ge.

14. Procédé suivant l'une des revendications 10 à 13,
**caractérisé en ce que** les condensateurs de mémoire font partie d'un composant de mémoire FeRAM ou DRAM.
